# EUROPEAN PATENT APPLICATION

(11) **EP 1 916 665 A2**
(43) Date of publication of application: **30.04.2008**
(21) Application number: 07020812.9
(22) Date of filing: 24.10.2007
(51) Int. Cl.: G11C 13/02, G11C 16/02

(54) **Combined read/write circuit for memory**

(30) Priority: 25.10.2006 US 586115
(71) Applicant: Qimonda North America Corp., Cary, NC 27513 (US)
(72) Inventor: Nirschl, Thomas, 05452 Essex Junction VT (US); Happ, Thomas, Dr., 01109 Dresden (DE)
(74) Representative: Jehle, Volker Armin

(57) **Abstract**

A memory device includes an array portion of resistive memory cells organized in rows and columns, wherein the rows correspond to word lines and the columns correspond to bit lines. The device further includes a combined read/write circuit associated with each respective bit line in the array portion configured to read from or write to a resistive memory cell associated with the respective bit line.

## Description

### FIELD OF INVENTION

The present invention relates generally to a memory device, and more particularly to a circuit that incorporates both read and write circuitry therein, and methods associated therewith.

### BACKGROUND OF THE INVENTION

In the case of conventional memory devices, in particular conventional semiconductor memory devices, it is sometimes common to differentiate between functional memory devices (*e.g.*, PLAs, PALs, etc.) and table memory devices. For example, some table memory devices include ROM devices (Read Only Memory) such as PROMS, EPROMS, EEPROMS, flash memories, etc., and RAM devices (Random Access Memory or read-write memory) such as DRAMs and SRAMs.

In the case of SRAMs (Static Random Access Memory), individual memory cells consist of, for example, six transistors configured as a cross-coupled latch. In the case of DRAMs (Dynamic Random Access Memory), generally only one single, correspondingly controlled capacitive element (e.g., the gate-source capacitance of a MOSFET) is employed, wherein charge may be stored in the capacitance. The charge in a DRAM, however, remains for only a short time, and a periodic refresh must be performed, to maintain a data state. In contrast to the DRAM, the SRAM requires no refresh, and the data stored in the memory cell remains stored as long as an appropriate supply voltage is fed to the SRAM. Both SRAMs and DRAMs are considered volatile memories, wherein a data state is only retained as long as power is supplied thereto.

In contrast to volatile memory, non-volatile memory devices (NVMs), e.g., EPROMS, EEPROMS, and flash memories, exhibit a different property, wherein the stored data is retained even when the supply voltage associated therewith is switched off. This type of memory has several advantages for various types of mobile communications devices such as, for example, in an electronic rolodex on cell phones, wherein the data therein is retained even when the cell phone is turned off.

One-type of non-volatile memory that has recently been developed is called resistive or resistively switched memory devices. In such a resistive memory, a memory material positioned between two appropriate electrodes (i.e., an anode and a cathode) is placed, by appropriate switching processes, in a more or less conductive state, wherein the more conductive state corresponds to a logic "1", and the less conductive state corresponds to a logic "0" (or *vice versa).* Suitable resistive memories can be, for example, perovskite memory, as described in W.W. Zhuamg et al., "Novell Colossal Magnetoresistive Thin Film Nonvolatile Resistance Random Access Memory (RRAM)", IEDM 2002, resistive switching in binary oxides (OxRAM), for example, as described in I.G. Baek et.al., "Multi-layer crosspoint binary oxide resistive memory (OxRAM) for post-NAND storage application", IEDM 2005, phase change memory (PCRAM), and conductive bridging RAM (CBRAM).

In the case of phase change memory, an appropriate chalcogenide compound (*e.g.,* a GeSbTe or an AglnSbTe compound) may, for instance, be used as the active material that is positioned between the two corresponding electrodes. The chalcogenide compound material can be placed in an amorphous, *i.e.,* relatively weakly conductive, or a crystalline, *i.e.,* relatively strongly conductive state by means of appropriate switching processes, and thus behaves like a variable resistance element, which as highlighted above, may be exploited as differing data states.

In order to achieve a change in the phase change material from an amorphous state to a crystalline state, an appropriate heating current is applied to the electrodes, wherein the current heats the phase change material beyond the crystallization temperature thereof. This operation is sometimes called a SET operation. Similarly, a change of state from a crystalline state to an amorphous state is achieved by application of an appropriate heating current pulse, wherein the phase change material is heated beyond the melting temperature thereof, and the amorphous state is obtained during the rapid cooling process thereof. This operation is sometimes called a RESET operation. The combination of SET and RESET operations is one means by which data can be written to a phase change memory cell.

### SUMMARY OF THE INVENTION

The following presents a simplified summary in order to provide a basic understanding of one or more aspects of the invention. This summary is not an extensive overview of the invention, and is neither intended to identify key or critical elements of the invention, nor to delineate the scope thereof. Rather, the primary purpose of the summary is to present some concepts of the invention in a simplified form as a prelude to the more detailed description that is presented later.

The present invention is directed to a memory device comprising an array portion of memory cells organized in rows and columns. A combined read/write circuit is provided and is associated with each respective bit line in the array portion and is configured to read from or write to a memory cell associated with the respective bit line. A method of addressing a memory is also disclosed and comprises using combined read/write circuitry uniquely associated with a bit line to address a memory cell associated with the bit line.

The following description and annexed drawings set forth in detail certain illustrative aspects and implementations of the invention. These are indicative of only a few of the various ways in which the principles of the invention may be employed.

### BRIEF DESCRIPTION OF THE DRAWINGS

Fig. 1 is a block diagram illustrating a memory architecture according to an embodiment of the invention; and
Fig. 2 is a schematic diagram illustrating a memory architecture according to another embodiment of the invention.

### DETAILED DESCRIPTION OF THE INVENTION

One or more implementations of the present invention will now be described with reference to the attached drawings, wherein like reference numerals are used to refer to like elements throughout. The invention relates to a memory circuit architecture and associated method of addressing such an architecture.

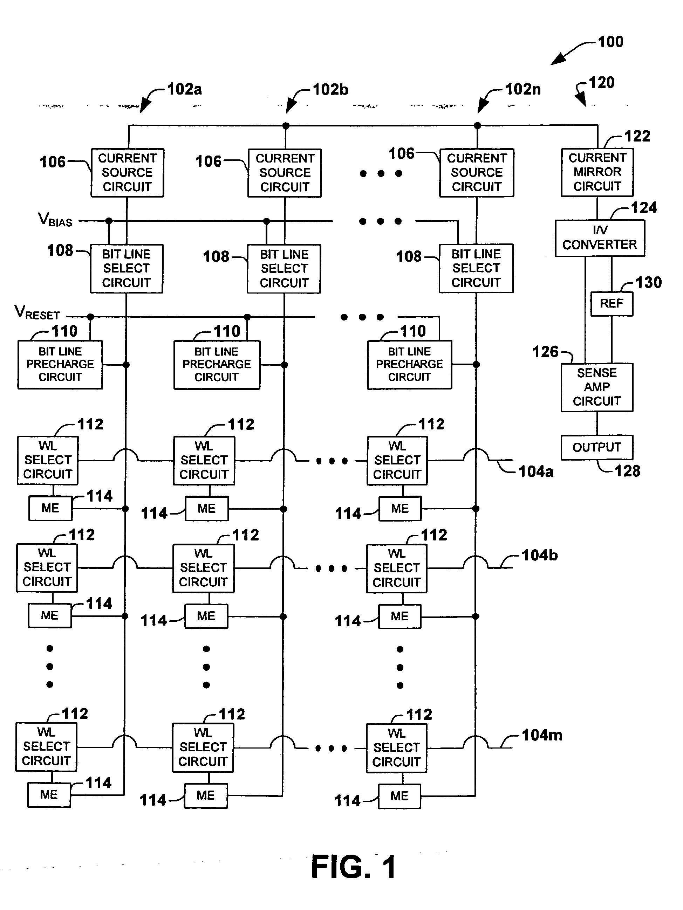

Turning to Fig. 1, a block diagram of a memory array architecture 100 is illustrated according to one embodiment of the invention. The architecture comprises a portion of a memory array containing a plurality of bit lines 102a-102n arranged in columns and a plurality of word lines 104a-104m arranged in rows, in one embodiment. Associated with each of the bit lines are a current source circuit 106, a bit line select circuit 108, and a bit line precharge circuit 110. Similarly, associated with each of the word lines are a word line select circuit 112 and a memory element 114 such as a phase change memory element in one embodiment. In one embodiment, the phase change memory element includes a component containing a transition metal oxide. Although various embodiments will be described herein in conjunction with a phase change memory, it should be understood that the present invention may be incorporated into other types of memory technologies, and all such memories are contemplated as falling within the scope of the present invention.

Still referring to Fig. 1, a read circuit 120 is associated with the memory array portion and operates to read data from the various memory elements 114 associated therewith. In one embodiment the read circuit 120 is operable to read one column (bit line) at a time, and the number of columns (n) associated with the read circuit may vary, such as 4, 8, 16 or 32 columns in various embodiments. Other alternative configurations may also be employed and are contemplated as falling within the scope of the present invention. In one embodiment the read circuit 120 comprises a current mirror circuit 122, a current-to-voltage (I/V) converter 124, and a sense amplifier circuit 126. In one embodiment the sense amplifier is configured to generate an output 128 that is a function of a comparison between the voltage from the I/V converter 124 and a reference voltage 130. In one embodiment the output current of the current mirror 122 is directly compared to a reference current to read data from a memory cell.

In accordance with one embodiment of the invention, the above architecture 100 provides a compact configuration of read/write circuitry that advantageously enables a reduction in the area and complexity over read and write circuitry employed in conventional array architectures. In a read operation, the bit line select circuits 108 are configured to selectively couple one of the bit lines 102a-102n to the read circuit 120. In one embodiment, the bit line select circuits 108 act as a switching matrix, wherein one bit line is operably coupled to the read circuit 120 while the remaining bit lines are electrically isolated therefrom. In one embodiment the bit-line select circuit is replaced by a direct electrical connection of the current source 106 and a bit-line, including the later mentioned clamp device.

As will be further appreciated *infra,* the bit line select circuit 108 is further configured to clamp the bit line voltage of the activated bit line, thereby protecting the memory elements associated therewith, as well as reducing variability associated with read conditions. In one embodiment of the invention, the bit line select circuit is configured to clamp the bit line voltage of an activated bit line to a voltage associated with a bias voltage (V_{BIAS}) that may differ from the supply voltage (V_{DD}) of the memory device.

Still referring to a read operation in conjunction with Fig. 1, the current source circuit 106 is operable to provide the required current to the activated bit line, wherein the current magnitude drawn therefrom is a function of the data state of the memory element (ME)114 being sensed. The current at the current source circuit 106 is mirrored at the current mirror circuit 122 of the read circuit 120 for sensing the data.

Further, in one embodiment of the invention, the bit line precharge circuit 110 is configured to pull each non-selected (or non-activated) bit line to a predetermined potential (e.g., circuit ground), thereby discharging such bit lines so that non-selected bit lines do not float. The bit line precharge circuit 110 associated with the activated bit line is configured to release the bit line from the predetermined potential so that it can rise to the bit line potential associated with the bias voltage of the bit line select circuit 108. Further, the current source circuit 106 is configured to isolate its respective non-selected bit line from the read circuit 120 to facilitate an accurate read.

In one embodiment, during a read, only one memory element 114 associated with the bit line is read (or sensed) at a time, based upon control of the respective word lines 104a-104m. In one embodiment the word line associated with the memory element to be sensed is activated (e.g., pulled high) while the remaining word lines are in-activated (e.g., pulled low). In this embodiment the associated word line select circuit 104 electrically couples the respective memory element 114 to the respective bit line. Based on the data state of the memory element 114, a unique current associated therewith is drawn on the bit line from the current source circuit 106, and that current is mirrored over to the read circuit 120 for sensing thereof.

In one embodiment the memory array is configured as a cross-point array where the bias on the bit-line and word-line is used to select cells within the array.

In one embodiment of the invention, each memory element 114 associated with the activated bit line is read in turn, based on a selective incremental activation and deactivation of the respective word lines 104a-104m. In order to read the data associated with the other bit lines, the respective bit line select circuit 108 is operable to activate the respective bit line and clamp it to the desired bit line read potential, while the other bit line select circuits deactivate the respective bit lines and the bit line precharge circuits 110 pull such non-selected bit lines to a predetermined voltage.

In a write operation for one or more cells associated with a given bit line, according to one embodiment, the current source circuit 106 is configured to isolate the respective bit line from the read circuit 120. Further, the current source circuit may operate as the current source for programming the selected memory element 114. In one embodiment of the invention where the memory element (ME) comprises a phase change memory element (PCE) two different programming currents are provided depending on the desired data state, and in such an embodiment the current source circuit 106 is configured to provide a SET current pulse, while other circuitry (to be discussed *infra)* operates to provide a RESET current pulse. For a SET operation (power limited) the current source 106 provides the SET current. To break-down the cell more efficiently, in one embodiment the RESET device 215 is used to apply a short break-down pulse at a higher voltage, before the applied power is limited by device 207.

Therefore in a SET write operation, according to one embodiment of the invention, the bit line select circuit 108 and current source 106 operate to clamp the bit line to a voltage associated with a bias potential, while the bit line precharge circuit 110 is inoperable. In the above manner, the bit line select circuit 108 operates as a write SET circuit in that the clamped voltage influences the SET current magnitude. For each memory element along the bit line that needs to be SET, the respective word line is activated to couple the respective phase change memory element 114 to the bit line, thereby allowing the SET current provided by the current source circuit 106 to flow therethrough. In one embodiment of the invention, a duration of the SET current pulse is dictated by a time period in which the respective word line is activated. In an alternative embodiment, the bit line precharge circuit 110 associated with the respective bit line may be selectively activated to shunt the SET current at the appropriate time, although this option consumes more power.

In one embodiment of the invention, each of the phase change memory elements 114 requiring a SET pulse are activated in an incremental manner, so that one cell is programmed after another until each desired cell has been SET. In an alternative embodiment of the invention, all cells requiring a SET pulse are coupled to the bit line in parallel so that each cell is SET in a concurrent manner. In addition, each bit line may be addressed in a concurrent manner since they each have their own write circuitry.

In a RESET write operation, the current source circuit 106 is not employed for the RESET current, and so the respective bit line select circuit 108 operates to isolate the bit line from the current source circuit, in one embodiment. According to one embodiment of the invention, the bit line precharge circuit 110 is configured to couple the respective bit line to a RESET potential having a value that is greater than the device supply potential of V_{DD}. In one embodiment the RESET potential is equal to the supply voltage. In one embodiment the RESET potential is smaller than the supply voltage. In another embodiment, charge pumps are used and the RESET potential is higher than the chip supply voltage. The resultant RESET current pulse magnitude is a function of the elevated RESET potential. Consequently, the bit line precharge circuit 110 operates as a write RESET circuit in that the RESET voltage influences the RESET current pulse magnitude. The RESET current pulse duration, in one embodiment, is dictated by the timing at which the respective word line is activated. In alternative embodiments, the RESET pulse duration may be dictated by the bit line precharge circuit 110 by either decoupling the RESET potential therefrom or shunting the RESET current to ground via another current path.

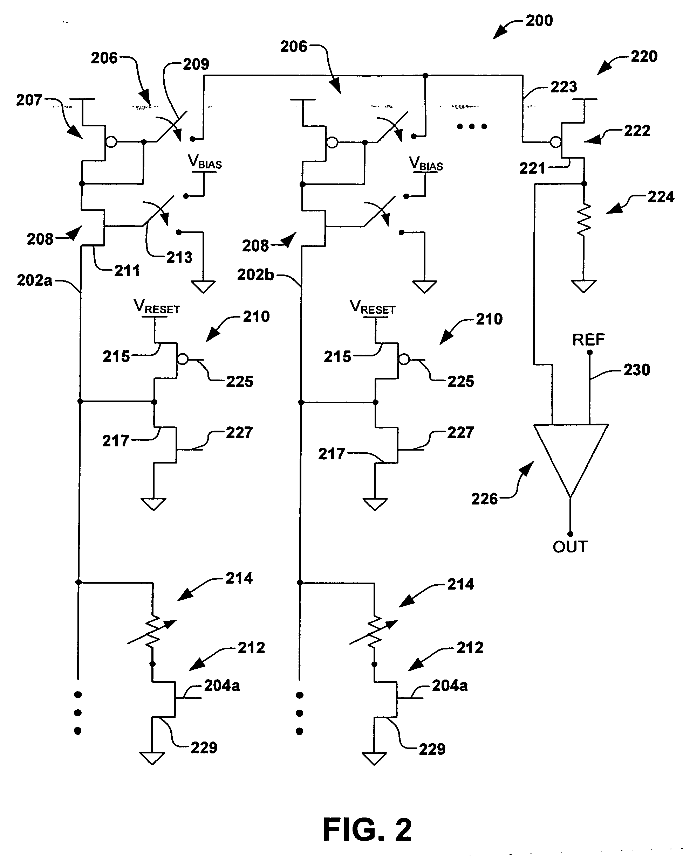

Turning now to Fig. 2, a schematic diagram is provided illustrating a read/write circuit architecture 200 according to another embodiment of the invention. The circuit architecture comprises a read circuit 220 that includes a transistor 221 having a gate control terminal 223 that is selectively coupled to other transistors 207 via a switch component 209. When closed, the transistor 207 that behaves as a current source circuit 206 for a respective bit line 202a couples to the transistor 221 to form a current mirror circuit 222. In the above manner, a current flowing through a bit line during a read is mirrored over to the read circuit 220 with a gain factor that is a function of the relative sizing of the transistors 207, 222.

The mirrored current in the current mirror circuit 222 is converted to a voltage by a converter circuit 224, such as a resistor in this exemplary embodiment. The sense voltage is then compared to a reference voltage 230 with a sense amplifier circuit 226, and the output state thereof is thus indicative of the state of the sensed memory cell 214.

As can be seen from the above discussion, the switch 209 associated with each current source circuit 206 is operable to selectively couple or isolate a respective bit line 202 from the read circuit 220. In one embodiment, the architecture 200 is configured so that of the plurality of bit lines 202a-202n that may be operably associated with a given read circuit 220, only one switch 209 is closed. Consequently, only that bit line is operably coupled to the read circuit, while the other bit line switches 209 are open, thereby electrically isolating such bit lines from the read circuit 220.

During a read of a memory cell 214 associated with a given bit line (*e.g*., bit line 202a), a transistor 211 is activated via a switch 213, when the switch 213 couples the control terminal of transistor 211 to a bias potential V_{BIAS}. In the above manner, the transistor 211 operates as a bit line select circuit 208 that couples the bit line 202a to the current source circuit 206.

Still referring to a read operation in conjunction with the architecture 200 of Fig. 2, a bit line precharge circuit 210 operates to ensure that the activated bit line 202a is not pulled to a predetermined potential, such as circuit ground in one embodiment. In such case the circuit 210 comprising transistors 215 and 217 are turned off by appropriate control signals at their control input terminals 225 and 227, respectively. Prior to a read, however, the transistor 217 may be activated to precharge the respective bit line 202a to a predetermined potential. In addition, for non-selected bit lines such as bit line 202b in Fig. 2 during a read, the transistor 217 is activated to pull the non-selected bit line to a predetermined potential such as circuit ground.

With the bit line precharge circuit 210 of the activated bit line deactivated, a word line select circuit 212 associated with the desired memory cell to be read is activated to thereby coupled the memory element 214 to the bit line 202a. In one embodiment, the word line select circuit 212 comprises a word line select transistor 229 that is turned on by the word line 204a going high. In the above manner, a current will flow in the bit line 202a that has a value that is a function of the state of the memory element 214 being read.

Further note that during a read operation, the bit line select circuit 208 operates as a bit line voltage clamp. When the transistor 211 is activated by the switch 213 being couples to V_{BIAS}, the bit line 202a is clamped to a voltage that is proportional to V_{BIAS}, thereby making the bit line voltage substantially independent of fluctuations in the supply voltage V_{DD}. Further, the value of V_{BIAS} can be advantageously selected independent of V_{DD} in one embodiment. In one embodiment an amplifier feedback loop is used together with the clamp device to improve the speed and accuracy of the clamp circuit.

The current on the bit line 202a is sourced from the transistor 207 of the current source circuit 206, and is mirrored over to the read circuit 220 due to the switch 209 being closed. The read circuit 220 then outputs a value or state of the sensed memory cell 214. Sensing of other cells along the activated bit line 202a may then proceed in an iterative fashion, in one embodiment, by selectively activating different word lines 204a-204m (not shown) one at a time.

Turning now to a programming or write operation associated with the architecture 200 of Fig. 2, a discussion will follow in conjunction with a resistive switching memory device such as a phase change memory. It should be understood, however, that the architecture highlighted herein is not so limited, and other memory components may be employed and are contemplated by the invention.

In the case of a phase change memory, a phase change element can be programmed to a SET state or a RESET state. Typically, a SET state is established with a lower magnitude current pulse for a longer duration of time that that used for a RESET pulse. The SET pulse acts to more slowly heat the phase change material to achieve a relatively crystalline state, while the RESET pulse acts to quickly heat/melt the material and then quickly quench the material to form an amorphous state.

In a SET operation, the bit line associated with a memory cell to be programmed is isolated from the read circuit 220 by opening the respective switch component 209 associated with the respective bit line. Further, the bit line select circuit 208 associated with the respective bit line is activated by the respective switch 213 by coupling the control terminal of the transistor 211 to the bias potential VBIAS. In one embodiment the bit line precharge circuit 210 of the respective bit line is inactive, wherein the transistors 215 and 217 are turned off.

Upon an activation of the respective word line associated with the memory element 214 to be SET, the-memory element is coupled to the activated bit line, thereby allowing the SET current to flow through the memory element 214. The voltage magnitude (and therefore the current magnitude of the SET pulse) on the bit line is limited by the transistor 211 acting as a clamp with respect to V_{BIAS}. In one embodiment a duration of the SET current pulse is dictated by a timing at which the respective word line is activated, wherein when the word line is again taken low, the SET pulse ends. In an alternative embodiment the transistor 217 in the bit line precharge circuit 210 can be activated to shunt the SET current to ground, although such a solution draws a larger amount of power.

In a RESET operation, the respective bit line is again electrically isolated from the read circuit 220 by opening the respective switch 209. Further, the bit line select circuit 208 is deactivated by the respective switch 213 by coupling the control terminal of the transistor 211 to a low potential such as circuit ground. In the RESET operation, the bit line precharge circuit 210 is active, wherein the transistor 215 is turned on, while the transistor 217 is turned off (in many instances, the transistor 217 may have previously been on in order to ground the bit line when not active). By activating the transistor 215, the respective bit line is pulled up to a RESET voltage value V_{RESET}. In one embodiment, V_{RESET} is a value greater than the supply voltage V_{DD}. In one embodiment the RESET voltage is equal to or smaller than the supply voltage.

The respective word line associated with the memory cell to be programmed is activated. In one embodiment such activation comprises raising the word line high, thereby activating the transistor 229 and coupling the memory element 214 to the bit line. The RESET current, having a current value dictated by the elevated bit line voltage of approximately V_{RESET}, then flows through the memory element 214. In one embodiment the RESET pulse duration is dictated by the duration in which the transistor 229 is on in accordance with the elevated word line. In another embodiment, the RESET pulse duration is dictated by a timing at which the transistor 225 in the bit line precharge circuit 210 is on. In yet another alternative embodiment, the RESET pulse duration is dictated by a timing at which the transistor 227 is re-activated to thereby shunt the RESET current to ground.

In one embodiment of the invention 200 of Fig. 2, the programming of cells along a given bit line is performed one memory cell at a time. Further, since each bit line has its own program circuitry, programming can be performed along multiple bit lines concurrently. In an alternative embodiment, multiple cells can be SET along a given bit line in a concurrent manner. Then after the SET operation, multiple cells along a given bit line can be RESET in a concurrent manner (the SET/RESET order can further be switched).

Although the invention has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the invention. In addition, while a particular feature of the invention may have been disclosed with respect to only one of several implementations, such feature may be combined with one or more other features of the other implementations as may be desired and advantageous for any given or particular application. Furthermore, to the extent that the terms "including", "includes", "having", "has", "with", or variants thereof are used in either the detailed description and the claims, such terms are intended to be inclusive in a manner similar to the term "comprising".

## Claims

1. A memory device, comprising:
an array portion of memory cells organized in rows and columns, wherein the rows correspond to word lines and the columns correspond to bit lines; and
a combined read/write circuit associated with each respective bit line in the array portion configured to read from or write to a memory cell associated with the respective bit line.

2. The memory of claim 1, wherein the combined read/write circuit comprises a bit line select circuit configured to selectively couple the respective bit line to a sense line that is associated with each of the bit lines in the array portion.

3. The memory of claim 1, wherein the memory comprises a phase change memory, and wherein the combined read/write circuit comprises a write set circuit portion configured to influence a current set pulse magnitude provided to a phase change element associated with a selected word line for the respective bit line in a set operation.

4. The memory of claim 1, wherein the memory comprises a phase change memory, and wherein the combined read/write circuit comprises a write reset circuit portion configured to provide a current reset pulse magnitude to a phase change element associated with a selected word line for the respective bit line in a reset operation.

5. The memory of claim 1, wherein the combined read/write circuit comprises a bit line precharge circuit portion configured to pull non-selected bit lines to a predetermined potential.

6. A resistive memory, comprising:
an array portion of resistive memory cells comprising a plurality of bit lines; and
a combined read/write circuit operably associated with a bit line, wherein the combined read/write circuit comprises a bit line select circuit configured to isolate the bit line from a sense circuit in a first state, and couple the bit line to a read bias potential in a second state.

7. The resistive memory of claim 6, wherein the combined read/write circuit further comprises a bit line precharge circuit configured to pull the bit line to a first predetermined potential when the bit line is not selected for addressing thereto.

8. The resistive memory of claim 7, wherein the bit line precharge circuit is further configured to pull the bit line to a second predetermined potential when a resistive element associated with the bit line is selected for programming to a reset state, wherein the second predetermined potential is equal to, less than, or greater than a supply voltage potential of the resistive memory.

9. The resistive memory of claim 7, wherein the bit line precharge circuit is further configured to allow the bit line to float when a resistive memory element associated with the bit line is selected for programming to a set state.

10. The resistive memory of claim 6, wherein the combined read/write circuit further comprises a selectively activatable current mirror circuit configured to mirror a current in the bit line to a sense circuit in the second state, and isolate the bit line from the sense circuit in the first state.

11. The resistive memory of claim 6, wherein the combined read/write circuit further comprises a word line select circuit configured to selectively couple a resistive element to the bit line.

12. The resistive memory of claim 11, wherein the word line select circuit is further configured to dictate a time period in which the resistive element is subjected to a programming current.

13. The resistive memory of claim 6, wherein the bit line select circuit is configured to dictate a time period in which the resistive element is subjected to a set state programming current.

14. The resistive memory of claim 6, wherein the resistive memory cells comprise phase change memory cells.

15. The resistive memory of claim 6, wherein the resistive memory cells comprise a component containing a transition metal oxide.

16. A memory device, comprising:
an array portion of resistive memory cells organized in rows and columns, wherein the rows correspond to word lines and the columns correspond to bit lines; and
means for addressing for read and write operations one or more memory cells along a bit line, wherein the addressing means is uniquely associated with the bit line.

17. The memory device of claim 16, further comprising sensing means operably associated with a plurality of bit lines for outputting a value associated with a data state of a memory cell associated with one of the plurality of bit lines.

18. The memory device of claim 16, wherein the addressing means comprises a bit line select means for selectively coupling the respective bit line to a sense line that is associated with each of the bit lines in the array portion.

19. The memory device of claim 16, wherein the memory comprises a resistive memory, and wherein the addressing means comprises a write set circuit means for influencing a current set pulse magnitude provided to a resistive element associated with a selected word line for the respective bit line in a set operation.

20. The memory device of claim 16, wherein the memory comprises a resistive memory, and wherein the addressing means comprises a write reset circuit means for providing a current reset pulse magnitude to a resistive element associated with a selected word line for the respective bit line in a reset operation.

21. The memory device of claim 16, wherein the resistive memory cells comprise a phase change memory cell.

22. A method of addressing a memory, comprising using combined read/write circuitry uniquely associated with a bit line to address a memory cell associated with the bit line.

23. The method of claim 22, wherein using the combined read/write circuitry comprises selectively coupling a bit line to a sense line that is associated with a plurality of bit lines of the memory.

24. The method of claim 22, wherein the memory comprises a phase change memory, and wherein using the combined read/write circuitry comprises:
coupling the bit line to a first predetermined potential to influence a programming current magnitude during a set write operation; and
coupling the bit line to a second predetermined potential that is greater than the first predetermined potential to influence a programming current magnitude during a reset write operation.

25. The method of claim 24, further comprising controlling a duration of the programming current by a selective coupling and decoupling of a phase change element from the bit line.
